# EUROPEAN PATENT APPLICATION

(11) **EP 2 302 670 A1**
(43) Date of publication of application: **30.03.2011**
(21) Application number: 09171531.8
(22) Date of filing: 28.09.2009
(51) Int. Cl.: H01L 21/68, H01L 21/00, H05K 13/04

(54) **Place station for a pick-and-place machine**

(71) Applicant: Nederlandse Organisatie voor Toegepast -Natuurwetenschappelijk Onderzoek TNO, 2628 VK Delft (NL)
(72) Inventor: Van der Donck, Jacques Cor Johan, 2403 EA Alphen aan den Rijn (NL); de Jager, Pieter Willem Herman, 3063 TB Rotterdam (NL)
(74) Representative: Hatzmann, Martin

(57) **Abstract**

A place station for a pick-and-place machine, comprising:
a place stage assembly comprising a place stage for supporting a substrate;
a covering for providing a clean environment at the substrate, the covering comprising a first opening in a first face of the covering through which a placement operation may be performed to a limited area of the substrate;
wherein the place stage and the covering are mounted for relative movement to allow the opening to achieve a selected relative position over the substrate.

## Description

The present invention relates to a place station for a pick-and-place machine that has particular application to the manufacture of three dimensional integrated circuits (3D ICs).

It is well known that pick-and-place machines are used to place a broad range of electronic components onto substrates, such as printed circuit boards. In a conventional back-end manufacturing setting, particle contamination is, for example, generated by the movement mechanisms of the pick-and-place machine is not considered a problem. Only in the extreme case in which contaminating particles clog around the bond pads might the welding of the bond wires or the soldering of the flip chip interconnects be impaired.

In manufacturing 3D ICs of the die-to-wafer and die-to-die varieties, it is necessary to create a stack of dies which is sufficiently precisely positioned to permit electrical interconnection between the dies in the stack by Through Silicon Vias (TSVs). The TSVs connect through bumps with a size of 1-2 microns. As a consequence, a stand-off distance between dies in the order of 1 micron is required. If a die surface is contaminated with a particle larger than the stand-off distance, the die cannot be located such that the TSVs make electrical contact and a non-functioning stack results. Such contamination has a disproportionate impact on the yield of functioning stacks, since contamination of any one die in the stack may result in a non-functioning stack.

It is an object of the present invention to provide a pick-and-place machine capable of meeting the increased cleanliness levels required when manufacturing 3D ICs. According to a first aspect, the present invention may provide a place station for a pick-and-place machine, comprising:
a place stage assembly comprising a place stage for supporting a substrate;
a covering for providing a clean environment at the substrate, the covering comprising a first opening in a first face of the covering through which a placement operation may be performed to a limited area of the substrate;
wherein the place stage and the covering are mounted for relative movement to allow the opening to achieve a selected relative position over the substrate.

In accordance with the first aspect of the present invention, the covering permits a placement operation to be performed, while shielding the substrate from contamination generated, inter alia, by the movement mechanisms of the pick/place head.

Preferably, the place station further comprises a clean gas source means operable to maintain a first gas flow outwardly through the first opening.

The first gas flow impedes the ingress of contamination generated, inter alia, by the movement mechanisms of the pick/place head through the first opening onto the substrate.

Preferably, the clean gas source means is operable to maintain a second gas flow that sweeps across the face of the substrate.

The second gas flow causes contamination present on the substrate or on the components on the substrate, for example, integrated circuit-bearing dies or wafers, is swept over the edges of the substrate.

In one embodiment, the covering comprises a plate. In a preferred embodiment, the covering comprises an enclosure.

Preferably, the first face of the enclosure is an upper face, and the enclosure further comprises a second opening in a second lower face of the enclosure, the clean gas source means being operable to maintain a third gas flow from beyond the periphery of the substrate towards the second opening.

The third gas flow causes contamination coming from the substrate or components to be directed towards the second opening from where it exits the enclosure. The third gas flow impedes the ingress of contamination generated by the movement mechanisms of the place stage assembly and/or the enclosure into the enclosure.

According to the second aspect, the present invention may provide a method of manufacturing a three dimensional integrated circuit using a pick-and-place machine, comprising:
covering a target wafer with a protective covering having a small opening; and
performing die stacking operations on the target wafer by
relatively moving the target wafer and the covering so as to achieve a relative position in which the small opening is over the next destination stack;
placing the next die on the next destination stack.

Further aspects and preferred features of the present invention are described in the following description and defined in the appended claims.

Exemplary embodiments of the present invention are hereinafter described with reference to the accompanying drawings, in which:
Figure 1 shows schematically the layout of a first pick-and-place machine;
Figure 2 shows a view of the place station shown in Figure 1;
Figure 3 shows a view of part of the place station shown in Figure 2 that illustrates the flow of clean air within the mini-environment enclosure;
Figure 4 shows schematically the layout of a second pick-and-place machine;
Figure 5(a),(b),(c) show the process sequence for the second pick-and-place machine;
Figure 6 shows schematically the layout of a third pick-and-place machine; and
Figure 7(a),(b),(c) show the process sequence for the third pick-and-place machine; and
Figure 8 shows schematically the layout of a fourth pick-and-place machine.

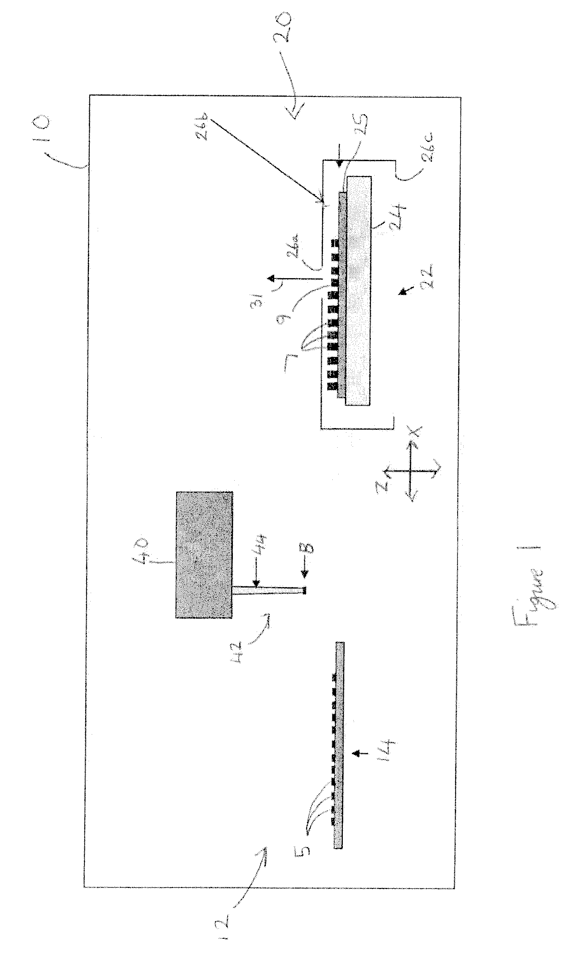

A first pick-and-place machine generally designated 10 is shown in Figure 1.

The machine 10 comprises a pick station 12 which includes a substrate in the form of a pick-up wafer 14. The pick-up wafer 14 contains an array of dies 5 for use in 3D IC manufacture. The pick station 12 holds the pick-up wafer 14 such that the dies 5 are presented in a horizontal orientation ready for picking.

The machine 10 further comprises a place station 20. The place station 20 comprises a place stage assembly 22 comprising a place stage 24 that supports a substrate in the form of a target wafer 25 in a horizontal orientation and a movement mechanism (not shown) for moving the place stage 24 in the X and Z axes as indicated and in the unlabelled Y axis (perpendicular to the plane of the paper). The target wafer 25 hosts stacks 7 of dies as they are being created.

The place station 20 further comprises an enclosure 26 which encloses the place stage 24, the target wafer 25 and the stacks 7 under creation and creates a mini-environment within which higher levels of cleanliness are maintained than in the rest of the pick-and-place machine 10. The mini-environment enclosure 26 comprises a top opening 26a formed in an upper face 26b through which a placement operation onto the target wafer 25 can be performed as described below, and a bottom opening 26c through which the unshown movement mechanism of the place stage assembly 22 is coupled to the place stage 24. The mini-environment enclosure 26 is held in a fixed position and the movement mechanism of the place stage assembly 22 permits the position of the place stage 24 to be adjusted in the X and Y plane such that the opening 26a can be aligned anywhere over the target wafer 25. Further, the movement mechanism of the place stage assembly 22 permits the position of the place station 24 to be adjusted in the Z direction to allow a fully stacked wafer 25 to be removed from the mini-environment enclosure 26 and replaced.

In other embodiments, the mini-environment enclosure 26 need not be fixed and it may be mounted to move relative to the place stage 24.

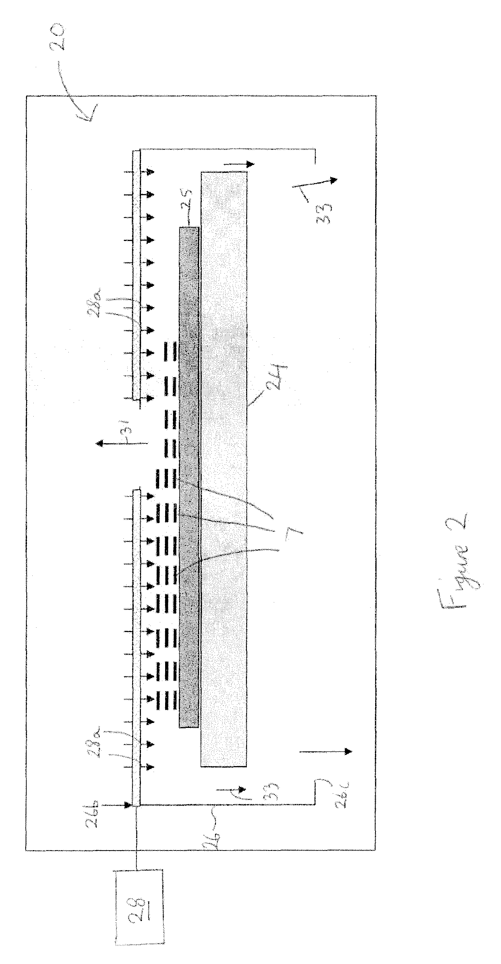

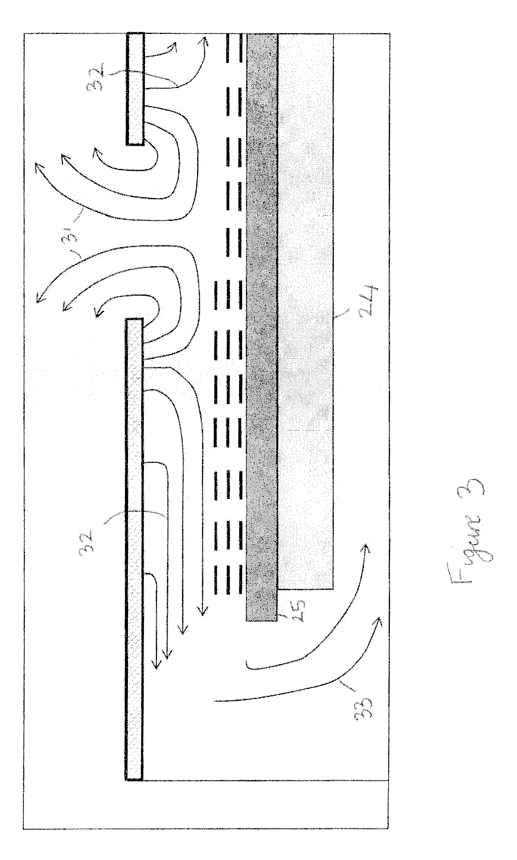

Referring to Figure 2, the place station 20 further comprises a clean air source 28 which injects ultra clean dry air into the mini-environment enclosure 26 through an array of nozzles 28a formed in its upper face 26b. Referring to Figure 3, the clean air source 28 establishes a first air flow 31 which flows from inside the enclosure 26 outwardly through the opening 26. The clean air source 28 also establishes a second air flow 32 which sweeps across the face of the target wafer 25. The clean air source also establishes a third air flow 33 which flows from beyond the peripheral edges of the target wafer 25 and place stage 24 downwardly towards the bottom opening 26c.

Referring to Figure 1, the machine 10 further comprises a transport robot 40 moveable between the pick station 12 and the place station 14. The robot 40 carries a pick/place head 42, having a nozzle 44, for picking and placing a die 5.

In operation, the robot 40 is positioned over the pick-up wafer 14. To start the current pick-and-place cycle, a particular die, designated 8, is picked up via its top face by the pick/place head 42. The robot 40 then starts to move the die 8 along a transport path to a destination stack designated 9 at the target wafer 25. As the robot 40 progresses along the transport path, the place stage 24 is manoeuvered such that the destination stack 9 is in alignment with the opening 26a. Upon reaching the place station 20, the pick/place head 42 performs a place operation through the opening 26a stacking the die 8 on the destination stack 9. The first air flow 31 provides a curtain or barrier which prevents particle contamination generated, inter alia, by the movement mechanisms of the robot 40 from entering the mini-environment enclosure 26 via the opening 26a. The second gas flow 32 causes particle contamination that does manage to find its way into the mini-environment enclosure 26 to be swept away from the exposed surfaces of the stack 7, thereby allowing an accurate stacking operation to be performed and electrical interconnection between the dies in a stack to be made. The third air flow 33 carries any particle contamination entrained in the second air flow 32 towards the bottom opening 26c and out of the mini-environment. The third air flow 33 also provides a curtain or barrier which prevents particle contamination generated, inter alia, by the movement mechanism of the place stage assembly 22 from entering the mini-environment enclosure 26 via the bottom opening 26c.

It will be appreciated that the provision of an enclosure 26 at the place station 20 enables a mini-environment of high cleanliness to be established locally around the exposed faces of the die stacks, thereby permitting accurate stacking operations to be achieved and isolating the die stacks from the particle contamination generated by the various movement mechanisms of the pick-and-place machine 10.

When subsequently, parts similar to those described in relation to the first pick-and-place machine shown in Figures 1 to 3 are referred to, the same reference numeral is used.

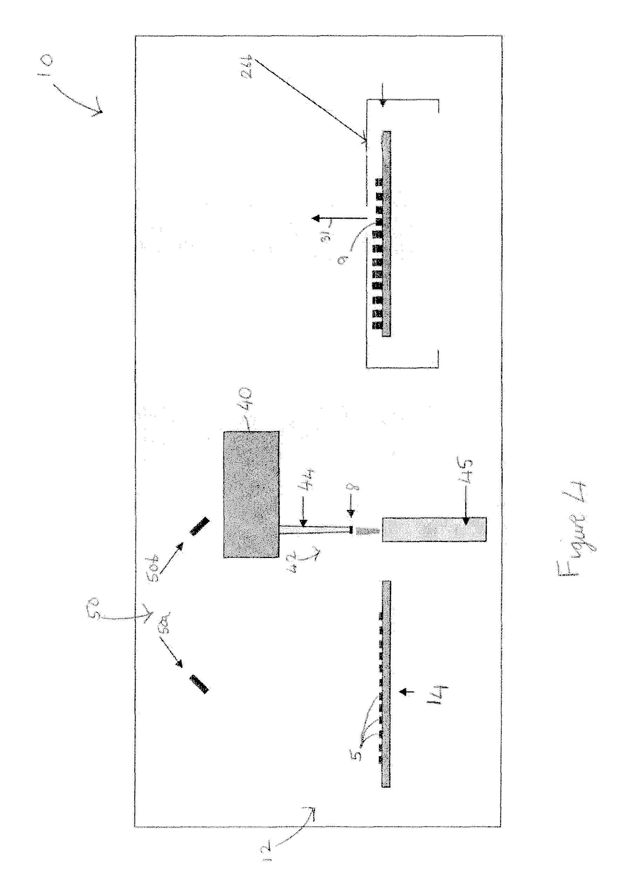

A second pick-and-place machine 10 is shown in Figure 4. The second pick-and-place machine differs from the first pick-and-place machine in that a cleaning unit 45 in the form of a laser configured to perform direct cleaning and an optical assembly 50 comprising a plurality of adjustable mirrors 50a, 50b are also provided.

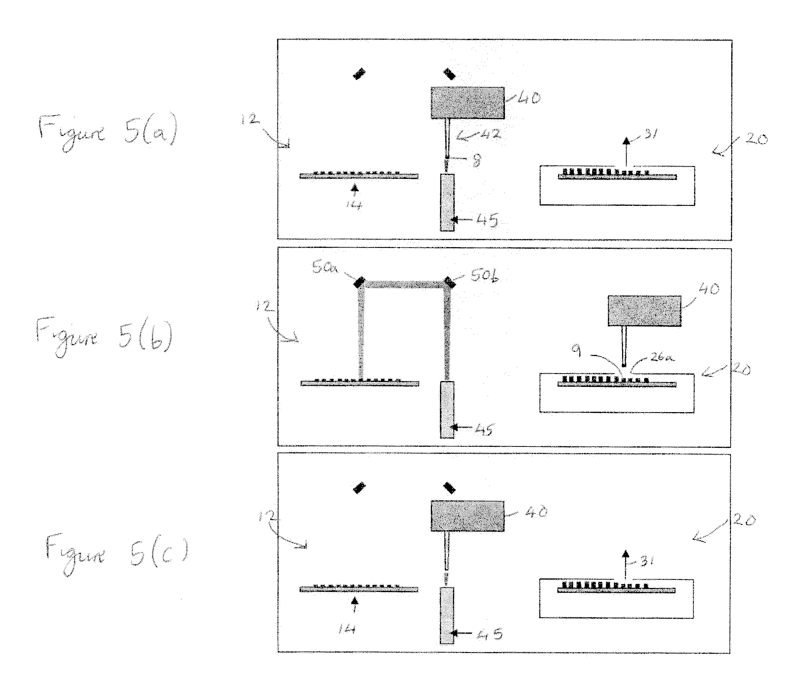

The operation of the second pick-and-place machine is now explained with references to Figures 5(a),(b), and (c). The pick/place head 42 picks up the die 8 and starts to move along the transport path towards the place station 20. Partway along the transport path, the bottom face of the die 8 is directly cleaned by the laser of the cleaning unit 45 as shown in Figure 5(a). Next, as shown in Figure 5(b), the robot 40 moves the die along the transport path to a position over the destination stack 9 and the opening 26a. Meanwhile, the cleaning unit 45 performs direct laser cleaning of the top face of the die scheduled to be picked up in the next pick-and-place cycle. Finally, the pick-place head 42 performs the place operation through the opening 26a stacking the die 8 on the destination stack 9 and returns along the transport path back to the pick station 12. Partway along the transport path, the cleaning unit 45 performs direct laser cleaning of the nozzle 44 as shown in Figure 5(c).

It will be appreciated that, in each pick-and-place cycle, the nozzle 44 is pre-cleaned (Figure 5(c)) and the top face (Figure 5(b)) and the bottom face (Figure 5(a)) of the die 8 that is transported are cleaned prior to the placement operation to ensure that the die is in a clean condition for entry into the mini-environment enclosure 26 and placement.

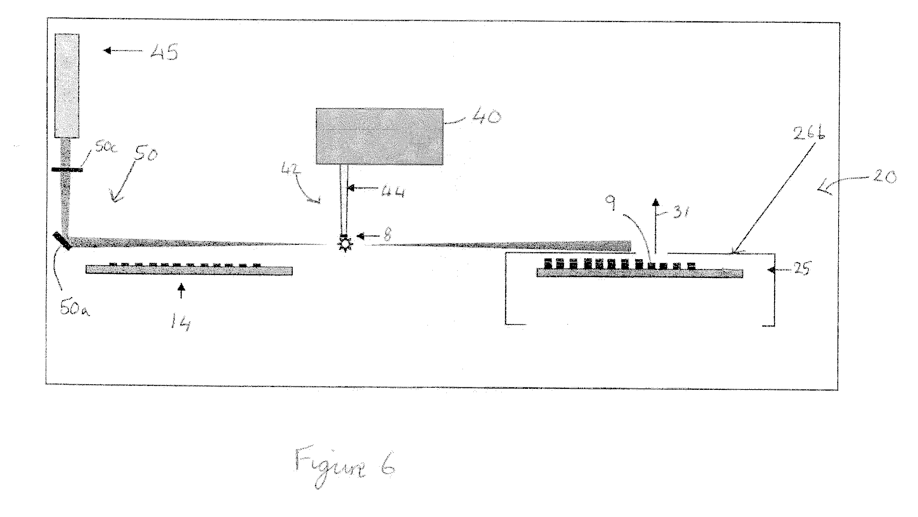

A third pick-and-place machine 10 is shown in Figure 6. The third pick-and-place machine differs from the first pick-and-place machine in that a cleaning unit 45 in the form of a laser configured to perform shockwave cleaning and an optical assembly comprising an adjustable mirror 50a and a lens 50c are also provided.

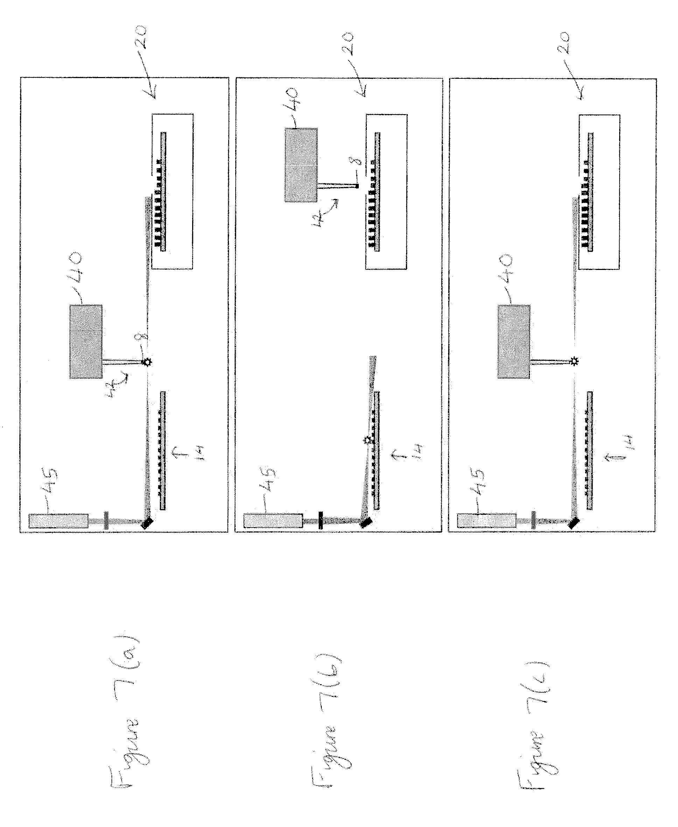

The operation of the second pick-and-place machine is now explained with references to Figures 7(a),(b), and (c). The pick/place head 42 picks up the die 8 and starts to move along the transport path towards the place station 20. Partway along the transport path, the bottom face of the die 8 is shockwave cleaned by the laser of the cleaning unit 45 as shown in Figure 7(a). Next, as shown in Figure 7(b), the robot 40 moves the die along the transport path to a position over the destination stack 9 and the opening 26a. Meanwhile, the cleaning unit 45 performs shockwave laser cleaning of the top face of the die scheduled to be picked up in the next pick-and-place cycle. Finally, the pick-place head 42 performs the place operation through the opening 26a stacking the die 8 on the destination stack 9 and returns along the transport path back to the pick station 12. Partway along the transport path, the cleaning unit 45 performs shockwave laser cleaning of the nozzle 44 as shown in Figure 7(c).

It will be appreciated that, in each pick-and-place cycle, the nozzle 44 is pre-cleaned (Figure 7(c)) and the top face (Figure 7(b)) and the bottom face (Figure 7(a)) of the die 8 that is transported are cleaned prior to the placement operation to ensure that the die is in a clean condition for entry into the mini-environment enclosure 26 and placement.

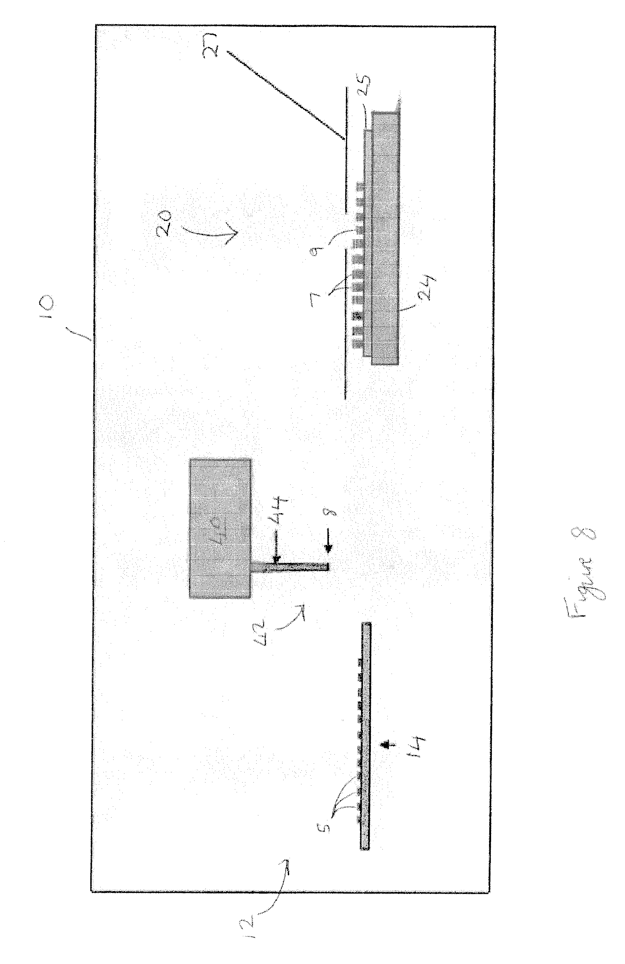

A fourth pick-and-place machine is shown in Figure 8. The fourth pick-and-place machine differs from the first pick-and-place machine in that, instead of a covering in the form of an enclosure, the covering comprises a protective cover plate 27 and in that it does not include a clean air source. The fourth pick-and-place machine works, mutatis mutandis, like the first pick-and-place machine with the plate 27 allowing a placement operation to be performed, while shielding the target wafer 25 from contamination generated, inter alia, by the movement mechanisms of the pick/place head 42. In a variation of the fourth pick-and-place machine, a clean air source may be provided to generate the first and/or second air flows 31, 32. Similarly, a cleaning unit 45 may also be provided.

In other embodiments, multiple clean air sources 28 can be used to create the first, second, and third air flows 31, 32, 33.

In other embodiments, the cleaning unit 45 may clean by nano spray/ocean spray, megasonic cleaning, high voltage cleaning, wet laser cleaning/steam laser cleaning, liquid jet, cleaning by ultrasonic nozzle, brushing, laser ablation, scrubbing (PVA+UPW), CO₂ snow, air knife/air jet or combinations thereof. If a wet cleaning technique is used, the die 8 must be dried before placing. Suitable drying techniques include light (visible of IR), laser (visible of IR), microwave technology, air knife, hot air or combinations thereof.

## Claims

1. A place station for a pick-and-place machine, comprising:
a place stage assembly comprising a place stage for supporting a substrate;
a covering for providing a clean environment at the substrate, the covering comprising a first opening in a first face of the covering through which a placement operation may be performed to a limited area of the substrate;
wherein the place stage and the covering are mounted for relative movement to allow the opening to achieve a selected relative position over the substrate.

2. A place station as in claim 1, wherein the covering comprises a plate.

3. A place station as in claim 1, wherein the covering comprises an enclosure.

4. A place station as in any preceding claim, further comprising a clean gas source means operable to maintain a first gas flow outwardly through the first opening.

5. A place station as in any preceding claim, wherein the clean gas source means is operable to maintain a second gas flow that sweeps across the face of the substrate.

6. A place station as in claims 4 or 5, when dependent on claim 3, wherein the first face of the enclosure is an upper face, and the enclosure further comprises a second opening in a second, lower face of the enclosure, the clean gas source means being operable to maintain a third gas flow from beyond the periphery of the substrate towards the second opening.

7. A pick-and-place machine comprising a pick station, a place station as in any preceding claim, and a pick/place head for transporting a component from the pick station along a transport path to the place station.

8. A machine as in claim 7, operable to pick and place dies in the manufacture of three dimensional integrated circuits.

9. A method of manufacturing a three dimensional integrated circuit using a pick-and-place machine, comprising:
covering a target wafer with a protective covering having a small opening; and
performing die stacking operations on the target wafer by
relatively moving the target wafer and the cover so as to achieve a relative position in which the small opening is over the next destination stack;
placing the next die on the next destination stack.

10. A method as in claim 9, wherein the covering comprises a plate.

11. A method as in claim 9, wherein the covering comprises an enclosure.

12. A method as in claims 10 or 11, comprising establishing a first gas flow outwardly through the small opening.

13. A method as in any of claims 10 to 12, further comprising establishing a second gas flow that sweeps across the top faces of the die stacks.

14. A method as in claims 12 or 13, when dependent on claim 11, wherein the same opening is in an upper face of the enclosure, and the enclosure further comprises a further opening in a lower face of the enclosure, the method further comprising establishing a third gas flow from beyond the periphery of the target wafer towards the further opening.

15. A method as in any of claims 10 to 14, further comprising cleaning the faces of a die prior to the stacking operation.

16. A method as in claim 15, wherein a first face of the die is cleaned after the die is picked up and before it is stacked.

17. A method as in claims 15 or 16, wherein a second face of the die is cleaned prior to the die being picked up.
